# EUROPEAN PATENT APPLICATION

(11) **EP 3 451 366 A1**
(43) Date of publication of application: **06.03.2019**
(21) Application number: 17306132.6
(22) Date of filing: 01.09.2017
(51) Int. Cl.: H01L 21/3065

(54) **METHOD OF FORMING A CONDUCTIVE TRENCH OR VIA**

(71) Applicant: Commissariat à l'Energie Atomique et aux Energies Alternatives, 75015 Paris (FR); LAM Research Corporation, Fremont, CA 94538 (US)
(72) Inventor: BARNOLA, Sébastien, 38190 VILLARD-BONNOT (FR); MAGIS, Thomas, 38000 GRENOBLE (FR); POLLET, Olivier, 38000 GRENOBLE (FR); CHAUVET, Nicolas, 38120 SAINT-EGREVE (FR); GAUCHER, François, 38000 GRENOBLE (FR)
(74) Representative: Cabinet Beaumont

(57) **Abstract**

The present disclosure concerns a method of forming a trench or via in a silicon layer (304), the method comprising: applying alternating etching and polymerization steps to a region of the silicon layer (304) to form the trench or via, the region being delimited by a mask layer; removing the mask layer; and performing plasma etching to enlarge the width of an opening region (316) of the trench or via.

## Description

### FIELD

The present disclosure relates to the field of integrated circuits, and in particular to a method for forming a filled trench or via, for example based on a TSV-First (Through Silicon Via - First) integration scheme.

### BACKGROUND

There are many known techniques for etching conductive vias or trenches that extend entirely or partially through silicon layers. The higher the aspect ratio of such trenches or vias, the greater the density of the interconnections that are possible.

The so-called "Bosch" method for HAR (high aspect ratio) silicon etching involves alternating etching and polymerization steps. For example, this approach is discussed in the publication by B. Wu et al. entitled "High Aspect Ratio Silicon Etch: A Review", Journal of applied physics 108, 051101 (2010). According to the Bosch method, a photoresist or oxide mask is formed over a silicon layer to delimit a zone in which a trench is to be formed. Deposition of C₄F₈ is then alternated with isotropic plasma etching using SF₆ in order to form a deep trench having for example a depth of 100 µm or more. An advantage of the Bosch method is that the etch rate can be relatively high, for example in the region of 10 µm/min for an aspect ratio of 10:1.

However, difficulties are encountered for higher aspect ratios of over 20:1 and up to 50:1 or more. Indeed, the plasma etching step is limited by the extent to which the neutral species can access the confined space at the bottom of the trench or via. The etch rate therefore decreases as the aspect ratio increases. This is known in the art at the ARDE (Aspect Ratio Dependent Etching) phenomena. For example, for an aspect ratio of 50:1, the Bosch method is not able to achieve an etch rate of over 2 µm/min while maintaining an acceptable profile.

A drawback of the Bosch method is that it is difficult to control the profile of the trench or via while maintaining an acceptable etch rate, leading to a poor deposition quality of the conductive material filling the trenches or vias.

### SUMMARY

It is an aim of embodiments of the present description to at least partially address one or more problems in the prior art.

According to one aspect, there is provided a method of forming a trench or via in a silicon layer, the method comprising: applying alternating etching and polymerization steps to a region of the silicon layer to form the trench or via, the region being delimited by a mask layer; removing the mask layer; and performing plasma etching to enlarge the width of an opening region of the trench or via.

According to one embodiment, performing the plasma etching enlarges a width of the opening region such that the opening of the trench or via has a first width greater than a second width between sidewalls of the trench or via.

According to one embodiment, the difference between the first and second widths is in the range 0.2 to 1.2 µm.

According to one embodiment, the method further comprises, after performing the plasma etching, lining the trench or via with an insulating layer and filling the trench or via with a conductive material.

According to one embodiment, the plasma etching to enlarge the width of the opening region is performed using a fluorine-based gas and/or a carbon-based gas.

According to one embodiment, the plasma etching is performed using one or more gases selected from the following group: SF₆; CHF₃; NF₃; CF₄; and CHₓF_{y}.

According to one embodiment, the plasma etching is an inductively coupled plasma etching operation, a reactive ion etching operation, or a deep reactive ion etching operation.

According to one embodiment, the opening region of the trench or via has a height in the range 0.5 to 3 µm.

According to one embodiment, the opening region forms a bevelled edge inclined by an angle of between 5° and 45° with respect to the sidewalls of the trench or via.

According to one embodiment, the trench or via has an aspect ratio of at least 20:1.

According to one embodiment, the trench or via has an aspect ratio of at least 50:1.

According to one embodiment, the operations of applying alternating etching and polymerization steps, removing the mask layer, and performing plasma etching are performed in a same clustering tool system.

### BRIEF DESCRIPTION OF THE DRAWINGS

The foregoing and other features and advantages will become apparent from the following detailed description of embodiments, given by way of illustration and not limitation with reference to the accompanying drawings, in which:
Figures 1A and 1B are cross-sectional views illustrating etching and polymerization operations according to the Bosch method;
Figures 2A and 2B are cross-sectional views representing a filling operation of the trench or via formed by the Bosch method;
Figures 3A to 3D are cross-sectional views illustrating operations in a method of forming a trench or via in a silicon layer according to example embodiment of the present disclosure; and
Figure 4 is a flow diagram illustrating operations in a method of forming a trench or via in a silicon layer according to example embodiment of the present disclosure.

### DETAILED DESCRIPTION

Throughout the present specification, the term "approximately" is used indicate a tolerance of plus or minus 10% of the value in question.

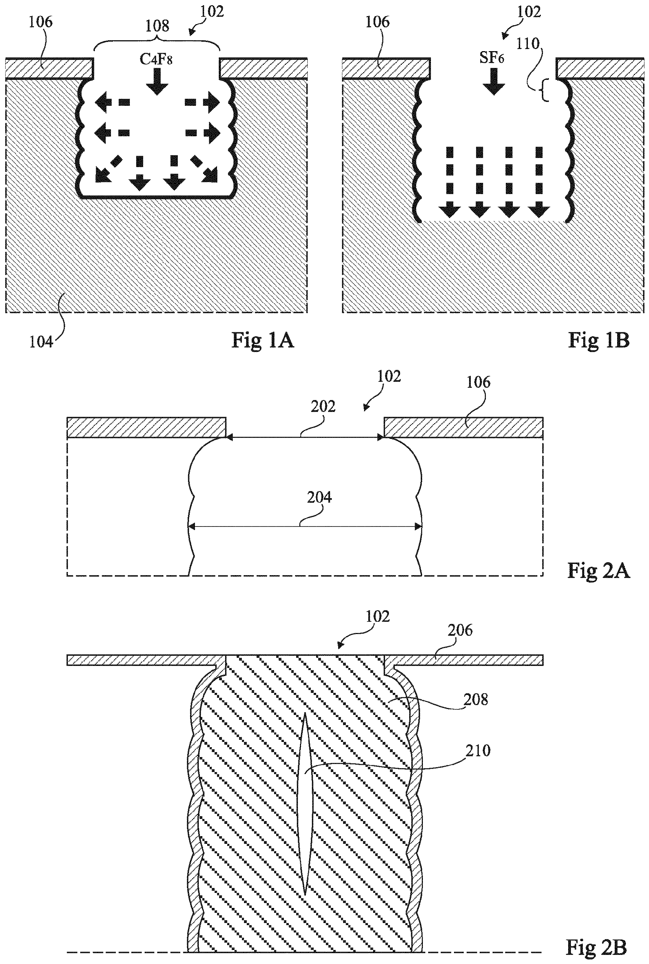

Figures 1A and 1B are cross-section views illustrating a trench 102 partway through formation according to the Bosch method. Such a method is for example described in more detail in the publication by B. Wu et al. mentioned above in the background section. The trench 102 is formed in a silicon layer 104, the surface of which is protected by a resist 106. The trench 102 is formed in an opening 108 in the resist 106.

Figure 1A illustrates a polymerization operation of the Bosch method in which the polymer C₄F₈ is deposited over the structure, and lines the walls and bottom of the trench 102. This polymer provides protection to the surfaces of the trench during subsequent etching, and particularly to the sidewalls of the trench 102.

Figure 1B illustrates an etching operation of the Bosch method in which an inductively coupled plasma (ICP) etch using SF₆ is performed. This etch rapidly removes the polymer layer on the bottom surface of the trench, and etches the underlying silicon, while only partially removing the polymer coating the sidewalls of the trench.

The Bosch method involves a succession of alternating polymerisation and etching cycles. The polymerisation parameters can be different from one cycle to the next, and the respective durations of the etching and polymerization operations can be adjusted, in order to achieve an anisotropic etch of a desired depth. It can be seen that the Bosch method results in sidewall "scallop" profiles 110, each plasma etching operating resulting in a corresponding "scallop".

Figures 2A and 2B are cross-section views representing a top portion of the trench 102 during subsequent lining and filling operations.

Figure 2A illustrates the hollow trench 102 resulting from the Bosch method of Figures 1A and 1B. It can be seen that, while the width of the trench 102 at its opening 202 has remained relatively constant thanks to protection from the resist 106, the width 204 between the sidewalls of the trench 102 below the opening has been increased relatively significantly by the successive etching steps.

Figure 2B illustrates the trench 102 following the removal of the resist 106, the deposition of an insulating layer 206 lining the trench, and the filling of the trench 102 with a conductive material 208. A CMP (chemical-mechanical polishing) operation has also for example been performed to planarize the surface of the structure down to the insulating layer 206.

During the filling operation, the enlarged spacing between the sidewalls of the trench 102 with respect to the trench width at the opening of the trench leads to defects. For example, as represented in Figure 2B, the present inventors have found that a cavity 210 may be present in the conductive filling 208. The void 210 for example extends vertically in the middle of the trench 102. Such a defect is non-desirable as it could lead to poor electrical conductivity in the trench 102, or even to an open circuit.

In order to minimise the impact of the ARDE phenomena, the Bosch method could be modified so that the plasma etching step is performed under high ion energy conditions and with RF bias pulsing. However, while such techniques could allow a trench or via to be formed having an improved profile, the etch rate will be reduced, for example to as low as 2 µm/min, which is undesirable for the formation of relatively deep trenches or vias.

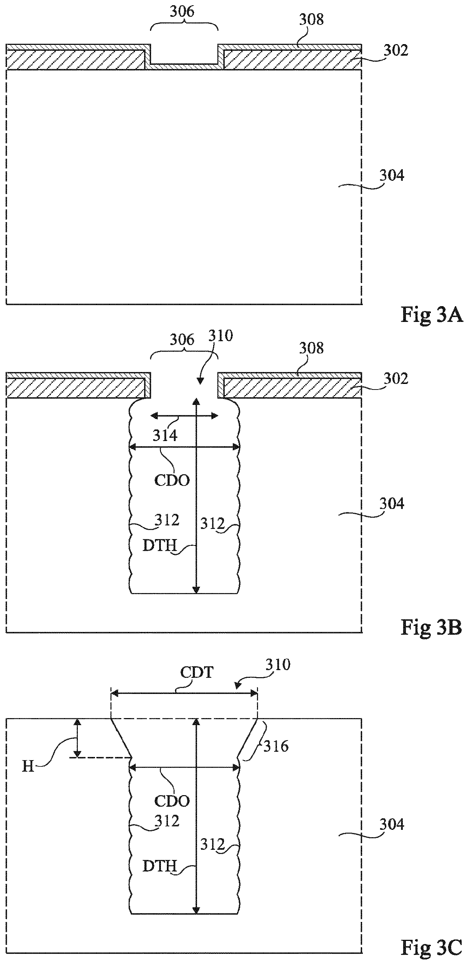

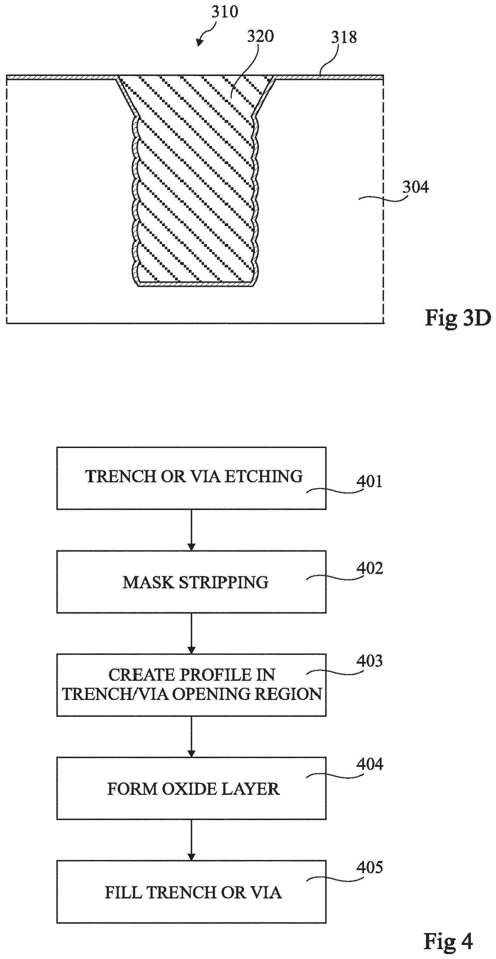

Figures 3A to 3D are cross-section views illustrating operations in a method of forming a trench or via according to an example embodiment of the present disclosure. The method is described in relation with the formation of a trench or via, the principles described herein being applicable to both trench and via formation. The method is for example part of a TSV-First process, although the techniques described herein could be applied to any trench or via formation in a silicon layer. The operations depicted by Figures 3A to 3D will now be described with reference to Figure 4.

Figure 4 is a flow diagram illustrating an example of operations in a method of forming a trench or via.

In an operation 401, one or more trenches and/or vias are etched, using for example a process based on the Bosch method described above with reference to Figures 1A and 1B.

For example, as represented in Figure 3A, this involves forming a mask layer 302 over a silicon layer 304 in which the trench or via is to be formed. An opening is formed in the mask layer 302, for example using a photolithography step, to define a region 306 in which the trench or via is to be formed. In one embodiment, the mask layer 302 is a photoresist. Alternatively, the mask layer 302 is a mask formed of a dielectric material, such as a mask based on SiₓO_{y}, SiₓN_{y} or SiₓO_{y}N_{z}. The mask is for example patterned using photolithography involving a further photoresist (not illustrated). In some embodiments, a passivation layer 308, such as a layer of carbon, may also be deposited over the structure, covering the mask layer 302 and lining the opening in the mask layer 302, prior to the trench or via formation.

Alternating polymerization and etching steps are then for example performed in order to form the trench or via.

The polymerization for example involves depositing a layer using a passivation gas such as C₄F₈, although other gases would be possible, such as more generally CₓF_{y}, or CHₓF_{y}, for example CHF₃ or C₄F₆, or any combination of these gases.

For example, the plasma etching is performed in an ICP (inductive coupled plasma), RIE (reactive ion etch) or DRIE (deep reactive ion etch) plasma chamber, and is for example performed using SF₆, CHF₃ or another gas.

Figure 3B is a cross-section view of the trench or via 310 resulting from the etching and polymerization steps. As with the example of Figure 2A, the width between the sidewalls 312, labelled CD0 in Figure 3B, is for example enlarged by the etching process with respect to the width 314 at the opening of the trench or via 310. The "scallop" profile of the trench or via 310 is illustrated in Figure 3B, resulting in a certain rugosity of the sidewalls 312. The width CD0 is for example measured as the maximum distance of a straight line between the sidewalls, which for example corresponds to a midpoint of the scallop where the plasma etch has penetrated the deepest.

The aspect ratio of the trench or via 310, defined as the ratio of the depth DTH to the width CD0 of the trench or via, is for example of at least 20:1, and in some embodiments up to 50:1 or more. For example, the trench or via has a width of between 1 and 10 µm and a depth of between 50 and 500 µm.

Referring again to Figure 4, in a subsequent operation 402, the mask layer 302 is stripped back. For example, in the case that the mask layer 302 is a resist, this is achieved using oxidizing chemicals, such as those based on O₂ or N₂, or reducing chemicals, such as those based on N₂, H₂ or NH₃. In the case that the mask layer 302 is a dielectric mask, wet etching based on HF or BOE (Buffered Oxide Etch) could be used, or plasma etching, such as ICP, RIE or µwave etching.

In a subsequent operation 403, a profile is created in an opening region of the trench or via. For example, with reference to Figure 3C, once the mask layer 302 has been stripped, the outer corners of the trench or via 310 are etched back in an opening region 316 of the trench or via 310. The opening region is for example defined as a region of height H extending into the trench or via from the surface of the silicon layer 304. The height H is for example in the range 0.5 to 3 µm.

For example, the opening region 316 is enlarged such that the opening of the trench or via, at the outer corner, has a width CDT greater than the width CD0 between the sidewalls 312 of the trench or via. In some embodiments, the difference between the widths CDT and CD0 is between 0.2 and 1.2 µm. As illustrated in Figure 3C, the opening region is for example modified to have a profile corresponding to a bevelled edge inclined by an angle of between 5° and 45° with respect to the sidewalls 312 of the trench or via.

The operation 403 of creating a profile in the opening region of the trench or via is for example implemented by a plasma etch using a fluorine-based gas and/or a carbon-based gas. For example, one or more of the following gases are used: SF₆; CHF₃; NF₃; CF₄; and CHₓF_{y}, where x and y are integers. In some embodiments, a mixture of a fluorine-based gas and a carbon-based gas could be used, or a plasma etching step using a fluorine-based gas could follow or precede a plasma etching step using a carbon-based gas. The etching is for example performed in an ICP, RIE or DRIE chamber. In one embodiment, the plasma etching is performed under the following conditions:
- Pressure: 5 mT to 50 mT;
- Source Power: 400 W to 1000 W;
- DC bias: 50 to 900 V, for example approximately 500 V;
- Gas: SF₆ or any other fluorine and/or carbon gas;
- Temperature: 5 to 60°C.

Plasma etching tends to attack corners at a faster rate than horizontal or vertical surfaces, as the sputtering yield is highest at 45°. Thus a bevelled edge can for example be created without significantly altering the other surfaces of the trench or via.

With reference again to Figure 4, in an operation 404, an oxide layer or other insulating layer is for example formed lining the trench or via, and in an operation 405, the trench or via is filled with a conductive material, such as a metal, or polysilicon.

Figure 3D illustrates an example of the trench or via 310 following the operations 404 and 405 of Figure 4, and in particular with an oxide layer 318 covering the silicon layer 304 and lining the trench or via 310, and a conductive material 320 filling the trench or via 310. Like with the embodiment of Figure 2B, a CMP step has also for example been performed to planarize the surface of the structure down to the oxide layer 318. However, as a result of the modified profile of the trench or via 310, no defects are present in the conductive filling 320.

An advantage of the embodiments described herein is that, by performing an additional operation in order to define the profile of an opening region of the trench or via, the quality of the deposition of the conductive material filling the trench can be improved. Furthermore, the definition of the profile in a separate operation to the formation of the trench or via decouples these processes from each other, thereby allowing a relatively rapid trench or via forming process to be implemented.

A further advantage of the process described herein is that the trench formation, mask stripping and profile formation steps may all be performed in a same clustering tool system.

Having thus described at least one illustrative embodiment, various alterations, modifications and improvements will readily occur to those skilled in the art. For example, while an embodiment has been described in relation with Figures 3A to 3D in which the trench or via extends partway through the silicon layer, in alternative embodiments it could extend completely through the silicon layer, and into another underlying layer, or in the case of a via, it could form a through hole.

## Claims

1. A method of forming a trench or via in a silicon layer (304), the method comprising:
applying alternating etching and polymerization steps to a region (306) of the silicon layer (304) to form the trench or via, the region (306) being delimited by a mask layer (302);
removing the mask layer (302); and
performing plasma etching to enlarge the width of an opening region (316) of the trench or via.

2. The method of claim 1, wherein performing said plasma etching enlarges a width of the opening region (316) such that the opening of the trench or via has a first width (CDT1) greater than a second width (CD0) between sidewalls (312) of the trench or via.

3. The method of claim 2, wherein the difference between the first and second widths is in the range 0.2 to 1.2 µm.

4. The method of any of claims 1 to 3, further comprising, after performing said plasma etching, lining the trench or via with an insulating layer (318) and filling the trench or via with a conductive material (320).

5. The method of any of claims 1 to 4, wherein the plasma etching to enlarge the width of the opening region is performed using a fluorine-based gas and/or a carbon-based gas.

6. The method of claim 5, wherein the plasma etching is performed using one or more gases selected from the following group:
SF₆;
CHF₃;
NF₃;
CF₄; and
CHₓF_{y}.

7. The method of any of claims 1 to 6, wherein said plasma etching is an inductively coupled plasma etching operation, a reactive ion etching operation, or a deep reactive ion etching operation.

8. The method of any of claims 1 to 7, wherein said opening region (316) of the trench or via has a height (H) in the range 0.5 to 3 µm.

9. The method of any of claims 1 to 8, wherein said opening region (316) forms a bevelled edge inclined by an angle of between 5° and 45° with respect to the sidewalls (312) of the trench or via.

10. The method of any of claims 1 to 9, wherein said trench or via has an aspect ratio of at least 20:1.

11. The method of any of claims 1 to 9, wherein said trench or via has an aspect ratio of at least 50:1.

12. The method of any of claims 1 to 11, wherein the operations of applying alternating etching and polymerization steps, removing the mask layer, and performing plasma etching are performed in a same clustering tool system.
